# EUROPEAN PATENT SPECIFICATION

(11) **EP 0 419 230 B1**
(45) Date of publication and mention of the grant of the patent: **04.05.1994**
(21) Application number: 90310250.7
(22) Date of filing: 19.09.1990
(51) Int. Cl.: H02M 7/5387, H03K 17/08, H02M 7/538

(54) **Snubber circuit of power converter**
Dämpferschaltung eines Leistungswandlers
Circuit amortisseur d'un convertisseur de puissance

(30) Priority: 20.09.1989 JP 243683/89
(43) Date of publication of application: 27.03.1991
(73) Proprietor: FUJI ELECTRIC CO. LTD., Kawasaki 210 (JP)
(72) Inventor: Kobayashi, Shinichi, Matumoto City 390-02 (JP); Yoshida, Masakazu, Tarumi-ku, Koube City 655 (JP); Takubo, Hiromu, Mitaka City 181 (JP)
(74) Representative: Bridge-Butler, Alan James

(56) References cited:
- WO-A-88/09085
- GB-A- 1 178 029
- IEEE TRANSACTIONS ON INDUSTRIAL ELECTRONICS. vol. IE-33, no. 2, 31 May 1986, NEW YORK US pages 185 - 192; K. S. RAJASHEKARA et al.: "Protection and switching-aid networks for transistor bridge inverters"

## Description

The present invention relates to power converters employing snubber circuits for protecting the semiconductor elements forming the power converter. One example of a power converter is an inverter.
Fig. 1 is a circuit diagram showing a first embodiment of the present invention;
Fig. 2 is a circuit diagram in which the circuit shown in Fig. 1 is applied to a three-phase inverter;
Fig. 3 is a circuit diagram showing a second embodiment of the present invention;
Fig. 4 is a circuit diagram showing an example of a known snubber circuit; and
Fig. 5 is a circuit diagram of a prior proposed improvement on the circuit of Figure 4.

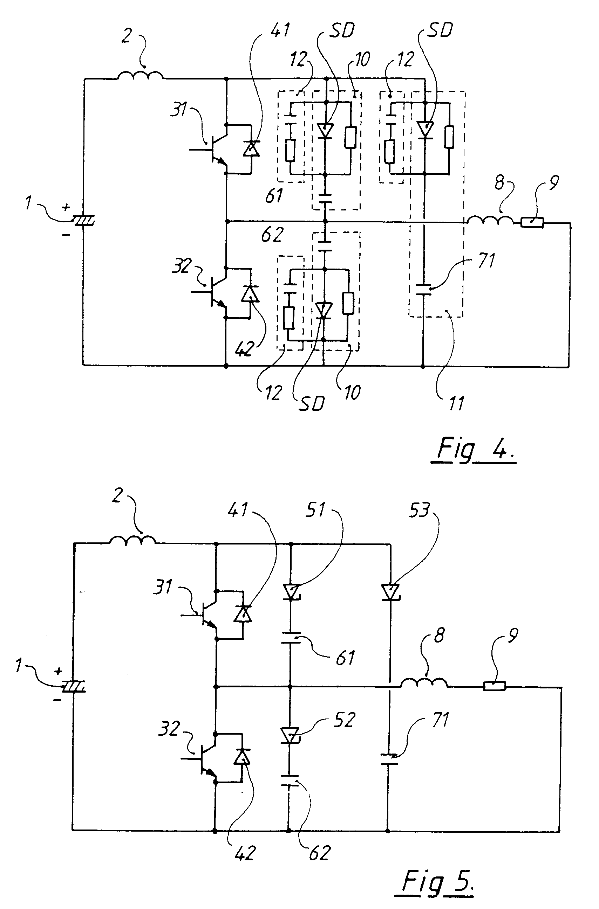

Fig. 4 shows by way of example the circuit of a typical power converter. This circuit may be used for an inverter for driving a motor, or for some other a.c. power supply. In this circuit, power transistors are used as self-turn-off power semiconductor elements. In Fig. 4, two free-wheeling diodes 41 and 42 are shown connected in parallel with two power transistors 31 and 32, respectively, and the transistor 32 is blocked when the transistor 31 is conducting. Under these conditions, an electric current is applied from a d.c. power supply 1 through the transistor 31 to an inductance 8 and a resistance 9 forming a load. When the transistor 31 is turned OFF, the electric current which has been flowing through the transistor 31 is applied to the free-wheeling diode 42 and the load current is kept constant. Charge and discharge type R-C-D snubber circuits 10 and a clamp type R-C-D snubber circuit 11 are provided for the purpose of reducing any surge voltage generated by energy stored in the stray inductance 2 of the connections from the d.c. power supply 1 to the transistors 31 and 32. Among those snubber circuits, the charge and discharge type snubber circuits 10 connected in parallel with the transistors 31 and 32 are used for the purpose of controlling the rate of change of voltage (dV/dt) so as to lighten the turn-off duty of the elements, and the clamp type snubber circuit 11 connected across both ends of the d.c. power supply 1 is used for the purpose of absorbing energy stored in the stray inductance 2. Besides, it happens sometimes that a driving circuit of one of the semiconductor elements 31 and 32 or a control circuit of the power converter malfunctions due to an excessive oscillatory voltage generated at the time of reverse recovery of snubber diodes SD in these snubber circuits 10 and 11. For the purpose of preventing such malfunctions from occurring, R-C snubbers 12, each consisting of a series circuit of a resistor and a capacitor, are connected to snubber diodes SD as shown in Fig. 4.

The power converter shown in Fig. 4, however, is complicated and also expensive due to the numerous components required. So, a power converter in which simplification and cost reduction of the snubber circuit are aimed at has been proposed in EP-A-0 379 346 (not published at the Priority Date of the present Application).

Fig. 5 shows a snubber circuit of the kind disclosed in said prior application. In Fig. 5, in order to remove an excessive oscillatory voltage generated during reverse-bias recovery of the snubber diodes SD shown in Fig. 4, the snubber diodes SD shown in Fig. 4 are replaced with voltage-regulating Zener diodes 51 to 53, and the R-C snubbers 12 and the resistors in parallel with the snubber diodes SD are removed. This snubber circuit shown in Fig. 5 is referred to as a C-ZD snubber circuit.

In view of the spread of the use of inverters, it is desirable to reduce the number of components even further for the purpose of cost reduction and improvement of reliability.

Thus the present invention relates to a power converter comprising a pair of self-turn-off power semiconductor elements connected in series across a d.c. power supply, wherein a snubber circuit comprising a first snubber capacitor and an asymmetrically conducting device connected in series is connected in parallel with each of said power semiconductor elements, the asymmetrically conducting device being arranged in the forward direction with respect to said power supply.

The invention is characterised in that each of said asymmetrically conducting devices is a voltage-regulator diode, and in that a further snubber capacitor is connected across said power supply in series with one or both of said voltage-regulator diodes.

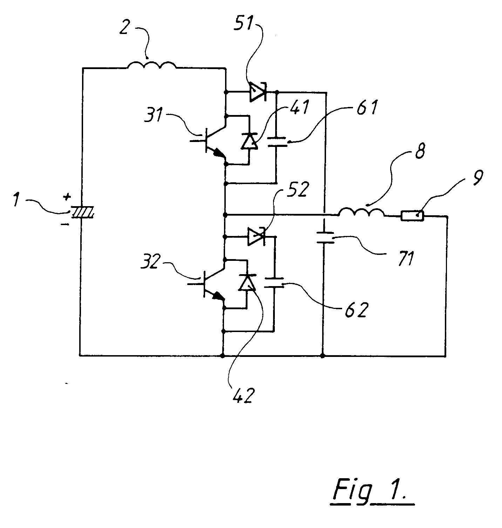

Fig. 1 is a circuit diagram of a first embodiment of the present invention. In Fig. 1, voltage-regulator diodes 51 and 52 replace the three voltage-regulator diodes 51, 52, and 53 that are used in the circuit of Fig. 5. Capacitors 61 and 62 connected to the voltage-regulator diodes 51 and 52 function to control the rate of change of voltage (dV/dt) generated by respective transistors 31 and 32, and a capacitor 71 functions to reduce any surge voltage generated by the stray inductance 2 of the power supply feeder line. The voltage-regulator diode 51 consumes energy when these two capacitors 61 and 71 discharge so as to prevent resonance phenomena.

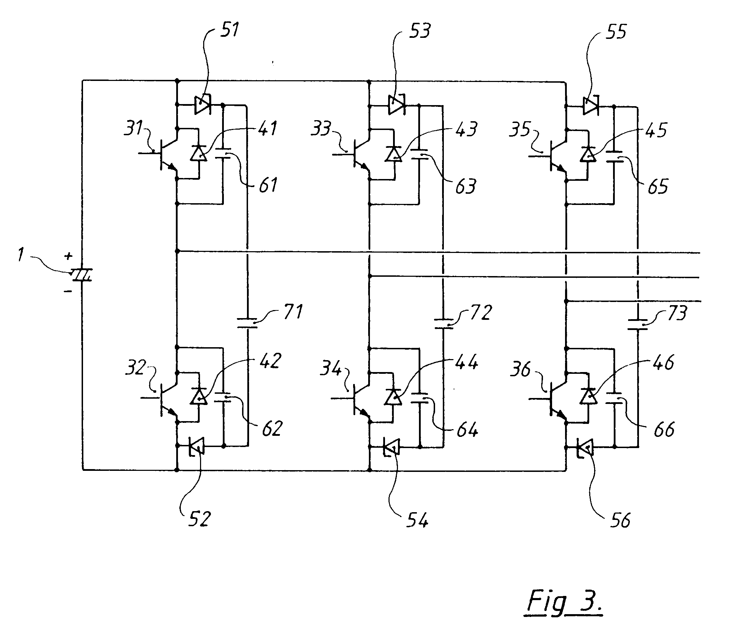

It is, of course, to be understood that the positions of the diode 52 and the capacitor 62 may be reversed. In this case the cathode of the diode 52 is connected to the negative pole of the power supply while its anode is connected to one side of the capacitor 62, the other side of which is connected to the junction between the transistors 31 and 32. The significance of this change will be understood in connection with the embodiment illustrated in Fig. 3 and the modification thereto described hereinafter.

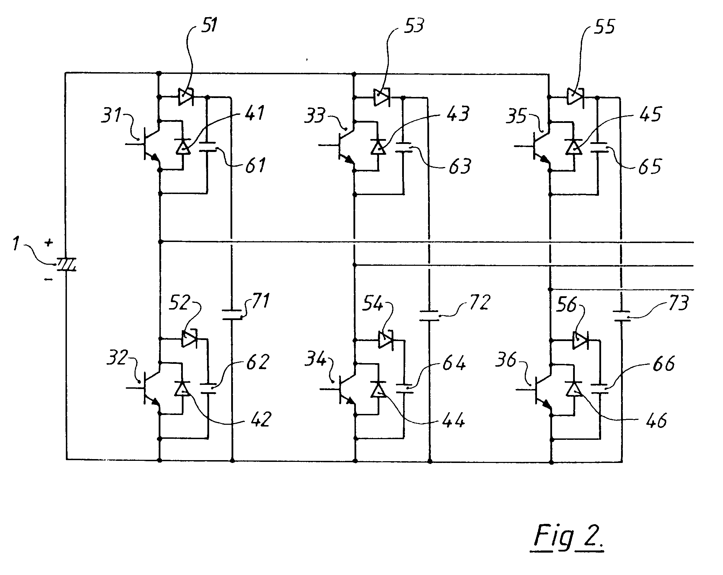

Fig. 2 shows an example of applying the circuit of Fig. 1, to a three-phase inverter circuit. The function of the snubber circuit of Fig. 2 is the same as that shown in Fig. 1.

Fig. 3 shows a second embodiment of the present invention. In Fig. 3, the Zener diodes 51 and 52 are made to take over an equal portion of the action of the Zener diode 53 of Fig. 5. In the embodiment shown in Fig. 1, the energy of the two capacitors 61 and 71 has to be consumed by the voltage-regulator diode 51. The advantage of the embodiment shown in Fig. 3 is that the energy of the clamp type snubber capacitor 71 is taken over by means of the two voltage-regulator diodes 51 and 52. Further, since the electric current applied to the capacitor 71 is usually larger than the electric current applied to the capacitor 61, it is advantageous to increase the Zener voltage in order to attenuate the resonance electric current of the capacitor 71. In the embodiment shown in Fig. 3, however, since two voltage-regulator diodes 51 and 52 are connected in series with the capacitor 71, the same effect is obtainable as if the Zener voltage were to be doubled. It is to be noted that in this embodiment the positions of the diode 52 and the capacitor 62 have been reversed relative to the arrangements shown in Figs. 1 and 2, as already mentioned in connection with a possible modification of Fig. 1.

In addition to the above-described embodiment of Fig. 3, an arrangement in which the terminals on the upper sides of the clamp type snubber capacitors 71, 72, and 73 are disconnected from the Zener diodes 51, 53, and 55, respectively, and connected to the positive pole of the d.c. power supply 1 may be considered. This circuit is nothing but a circuit in which the functions of the voltage-regulator diodes 51 and 52 of the arrangement shown in Fig. 2 are replaced with one another, and such a circuit, therefore, constitutes a further embodiment of the present invention.

In the above-described circuits in respective embodiments of the present invention, it has been assumed that power transistors are used as the self-turn-off power semiconductor elements, but it is a matter of course that the present invention is also applicable to the case in which another type of self-turn-off power semiconductor element such as an insulating gate type bipolar transistor or a field effect transistor is employed in place of the power transistor.

It will be seen that in a power converter according to the present invention, at least one of the voltage-regulator diodes connected in series with a capacitor in parallel with each self-turn-off power semiconductor element to form a charge and discharge snubber circuit is also used in conjunction with a further capacitor to form a clamp type snubber circuit connected between the positive and negative poles of the power supply. Accordingly, it is possible to reduce the quantity of components and simplify the circuit. Also, as the snubber circuit between the positive and negative poles is installed close to the power semiconductor elements, it is possible to reduce the inductance of the snubber circuit, thus increasing the surge voltage suppression effect.

## Claims

1. A power converter comprising a pair of self-turn-off power semiconductor elements (31,32) connected in series across a d.c. power supply (1), wherein a snubber circuit comprising a first snubber capacitor (61 or 62) and an asymmetrically conducting device (51 or 52) connected in series is connected in parallel with each of said power semiconductor elements, the asymmetrically conducting device being arranged in the forward direction with respect to said power supply, characterised in that each of said asymmetrically conducting devices is a voltage-regulator diode, and in that a further snubber capacitor (71) is connected across said power supply in series with one or both of said voltage-regulator diodes.

2. A power converter according to Claim 1, wherein the anode of a first one of said voltage-regulator diodes (51) is connected to the positive pole of the power supply, and wherein said further snubber capacitor is connected between the negative pole of the power supply and the cathode of said first regulator diode.

3. A power convertor according to Claim 1, wherein the cathode of a second one of said voltage-regulator diodes (52) is connected to the negative pole of the power supply, and wherein said further snubber capacitor is connected between the positive pole of the power supply and the anode of said second regulator diode.

4. A power converter according to Claim 1, wherein the anode of a first one of said voltage-regulator diodes (51), is connected to the positive pole of the power supply, wherein the cathode of a second one of said voltage-regulator diodes (52) is connected to the negative pole of the power supply, and wherein said further snubber capacitor is connected between the cathode of said first regulator diode and the anode of said second regulator diode.

## Patentansprüche

1. Leistungswandler, der ein Paar über einen Gleichstrom-Netzanschluß (1) in Serie geschaltete selbstschließende Leistungs-Halbleiterelemente (31,32) enthält, wobei eine Schutzschaltung einen ersten Schutzkondensator (61 oder 62) und eine in Serie geschaltete asymmetrisch stromleitende Einrichtung (51 oder 52) parallel zu jedem der Leistungs-Halbleiterelemente umfaßt, wobei die asymmetrisch stromleitende Einrichtung hinsichtlich des Netzanschlusses in Durchlaufrichtung angeordnet ist, dadurch gekennzeichnet, daß jede der asymmetrisch stromleitenden Einrichtungen eine Spannungsregler-Diode ist, und dadurch, daß ein weiterer Schutzkondensator (71) über den Netzanschluß mit einer oder beiden Spannungsregler-Dioden in Serie geschaltet ist.

2. Leistungswandler nach Anspruch 1, wobei die Anode einer ersten Spannungsregler-Diode (51) mit dem Pluspol des Netzanschlusses verbunden ist, und wobei der weitere Schutzkondensator zwischen den Minuspol des Netzanschlusses und die Kathode der ersten Regler-Diode geschaltet ist.

3. Leistungswandler nach Anspruch 1, wobei die Kathode einer zweiten Spannungsregler-Diode (52) mit dem Minuspol des Netzanschlusses verbunden ist, und wobei der weitere Schutzkondensator zwischen den Pluspol des Netzanschlusses und die Anode der zweiten Regler-Diode geschaltet ist.

4. Leistungswandler nach Anspruch 1, wobei die Anode einer ersten Spannungsregler-Diode (51) mit dem Pluspol des Netzanschlusses verbunden ist, wobei die Kathode einer zweiten Spannungsregler-Diode (52) mit dem Minuspol des Netzanschlusses verbunden ist, und wobei der weitere Schutzkondensator zwischen die Kathode der ersten Regler-Diode und die Anode der zweiten Regler-Diode geschaltet ist.

## Revendications

1. Convertisseur de puissance comportant une paire d'éléments (31,32) semi-conducteurs de puissance à blocage automatique montés en série entre les bornes d'une source (1) de courant continu, dans lequel un circuit amortisseur comprenant un premier condensateur d'amortissement (61 ou 62) et un dispositif (51 ou 52) à conduction asymétrique en série est monté en parallèle avec chacun desdits éléments semi-conducteurs de puissance, le dispositif à conduction asymétrique étant disposé vers l'avant par rapport à ladite source de courant, caractérisé en ce que chacun desdits dispositifs à conduction asymétrique est une diode régulatrice de tension, et en ce qu'un autre condensateur d'amortissement (71) est monté entre les bornes de ladite source de courant, en série avec au moins une desdites deux diodes régulatrices de tension.

2. Convertisseur de puissance selon la revendication 1, dans lequel l'anode d'une première desdites diodes (51) régulatrices de tension est reliée au pôle positif de la source de courant, et dans lequel ledit autre condensateur d'amortissement est monté entre le pôle négatif de la source de courant et la cathode de ladite première diode régulatrice.

3. Convertisseur de puissance selon la revendication 1, dans lequel la cathode d'une seconde desdites diodes (52) régulatrices de tension est reliée au pôle négatif de la source de courant, et dans lequel ledit autre condensateur d'amortissement est monté entre le pôle positif de la source de courant et l'anode de ladite seconde diode régulatrice.

4. Convertisseur de puissance selon la revendication 1, dans lequel l'anode d'une première desdites diodes (51) régulatrices de tension est reliée au pôle positif de la source de courant, dans lequel la cathode d'une seconde desdites diodes (52) régulatrices de tension est reliée au pôle négatif de la source de courant, et dans lequel ledit autre condensateur d'amortissement est monté entre la cathode de ladite première diode régulatrice et l'anode de ladite seconde diode régulatrice.
